# EUROPEAN PATENT APPLICATION

(11) **EP 4 261 521 A1**
(43) Date of publication of application: **18.10.2023**
(21) Application number: 21922565.3
(22) Date of filing: 13.12.2021
(51) Int. Cl.: G01M 17/007, G01B 21/26

(54) **SYNCHRONOUS SCREEN DISPLAY METHOD AND APPARATUS, AND VEHICLE MEASUREMENT SYSTEM**

(30) Priority: 26.01.2021 CN 202110106317
(71) Applicant: Autel Intelligent Technology Corp., Ltd., Shenzhen, Guangdong 518055 (CN)
(72) Inventor: ZHANG, Hua, Shenzhen, Guangdong 518055 (CN)
(74) Representative: Harris, Oliver John Richard
(86) International application number: PCT/CN2021/137479
(87) International publication number: WO 2022/160975

(57) **Abstract**

The present application relates to the technical field of automobile inspection. A synchronous screen display method, which is applied to a vehicle measurement system. The vehicle measurement system comprises a control end (10), a controlled end (20) and a vehicle measurement support, wherein the control end (10) is wirelessly connected to the controlled end (20). The method comprises: a controlled end (20) receiving a vehicle image sent by a camera component (110); the controlled end (20) sending the vehicle image to a control end (10) (120); the control end (10) determining a vehicle measurement result according to the vehicle image (130); the control end (10) determining a display interface for displaying the vehicle measurement result, and determining a synchronous display identification code corresponding to the display interface (140); the control end (10) sending the vehicle measurement result and the synchronous display identification code to the controlled end (20) (150); and according to the synchronous display identification code, the controlled end (20) calling the display interface corresponding to the synchronous display identification code, and displaying the vehicle measurement result on the display interface (160). The beneficial effect of real-time synchronous screen display between a controlled end (20) and a control end (10) is achieved.

## Description

### BACKGROUND

### Cross Reference

The present application claims priority to the Chinese patent application No. 202110106317.3 entitled "synchronous screen display method and apparatus, and vehicle measurement system" filed on January 26, 2021, to the China National Intellectual Property Administration, the entire contents of which are incorporated herein by reference.

### Technical Field

The present application relates to the technical field of automobile inspection, and particularly to a synchronous screen display method and apparatus, and a vehicle measurement system.

### Related Art

Currently, the existing automobile inspection equipment generally adopts the integrated machine mode or wireless mode. The integrated machine is bundled together, so that the space requirement for the equipment is relatively high. The user must conduct the operation in a certain fixed position, leading to poor convenience. However, when using a wireless mode, screen capture stream (capturing screen pictures in real-time to constitute a real-time video stream) and like modes are generally used for data transmission; however, the existing wireless mode has a relatively low data transmission efficiency and serious delay, so that the synchronous screen effect is poor.

### SUMMARY

In view of the above problems, the embodiments of the present invention provide a synchronous screen display method and apparatus, and a vehicle measurement system for solving the technical problem of poor synchronous screen effect existing in the prior art.

According to one aspect of the embodiments of the present invention, there is provided a synchronous screen display method, which is applied to a vehicle measurement system, the vehicle measurement system comprising a control end, a controlled end, and a vehicle measurement support. The control end is wirelessly connected to the controlled end, the controlled end is mounted to the vehicle measurement support, the vehicle measurement support includes a camera component, the camera component is wired or wirelessly connected to the controlled end, and the camera component is used for collecting a vehicle image and sending the collected vehicle image to the controlled end. The method includes:
the controlled end receiving the vehicle image sent by the camera component;
the controlled end sending the vehicle image to the control end;
the control end determining a vehicle measurement result according to the vehicle image;
the control end determining a display interface for displaying the vehicle measurement result, and determining a synchronous display identification code corresponding to the display interface;
the control end sending the vehicle measurement result and the synchronous display identification code to the controlled end; and
the controlled end calling a display interface corresponding to the synchronous display identification code according to the synchronous display identification code, and displaying the vehicle measurement result on the display interface.

In an alternative mode, the vehicle measurement result and the synchronous display identification code are character string data; the control end sending the vehicle measurement result and the synchronous display identification code to the controlled end comprises:
the control end converting the vehicle measurement result and the synchronous display identification code into binary data;
the control end compressing the binary data to obtain compressed data; and
the control end sending the compressed data to the controlled end.

In an alternative mode, before the controlled end sending the vehicle image to the control end, the method further includes:
the controlled end sending a connecting request to the control end;
the control end generating a response signal according to the connecting request;
and the controlled end establishing a communication connection with the control end according to the response signal.

In an alternative mode, after the controlled end establishing a communication connection with the control end according to the response signal, the method further includes:
the control end sending heartbeat data to the controlled end;
the controlled end responding to the heartbeat data and sending response data to the control end; and
the control end receiving the response heartbeat data.

In an alternative mode, before the controlled end receiving the vehicle image sent by the camera component, the method further includes:
the controlled end and the control end synchronously displaying a vehicle measurement interface;
the control end receiving an operation instruction of a user for a user interaction interface, and sending the operation instruction to the controlled end; and
after receiving the operation instruction, the controlled end controlling the camera component to collect vehicle image in response to the operation instruction.

In an alternative mode, after receiving the operation instruction, the controlled end responds to the operation instruction as follows: the controlled end switches and displays the vehicle measurement interface as an image collection interface, and generates a synchronous display identification code corresponding to the image collection interface; the controlled end sends the synchronous display identification code to the control end, so that the control end calls and displays the image collection interface.

According to another aspect of the embodiments of the present invention, there is provided a synchronous screen display method, which is applied to a controlled end of a vehicle measurement system, the vehicle measurement system comprising a control end, a controlled end, and a vehicle measurement support. The control end is wirelessly connected to the controlled end, the controlled end is mounted to the vehicle measurement support, the vehicle measurement support includes a camera component, the camera component is wired or wirelessly connected to the controlled end, and the camera component is used for collecting a vehicle image and sending the collected vehicle image to the controlled end. The method includes:
receiving the vehicle image sent by the camera component;
sending the vehicle image to the control end, so that the control end determines a vehicle measurement result according to the vehicle image, determines a display interface for displaying the vehicle measurement result, and determines a synchronous display identification code corresponding to the display interface;
receiving the vehicle measurement result and the synchronous display identification code sent by the control end;
and calling a display interface corresponding to the synchronous display identification code according to the synchronous display identification code, and displaying the vehicle measurement result on the display interface.

In an alternative mode, after the vehicle measurement result and the synchronous display identification code sent by the control end are received, the following steps are included. The compressed data is decompressed to obtain binary data; the binary data is converted into character string data, so as to obtain and receive the vehicle measurement result and the synchronous display identification code sent by the control end.

In an alternative mode, before sending the vehicle image to the control end, so that the control end determines a vehicle measurement result according to the vehicle image, determines a display interface for displaying the vehicle measurement result, and determines a synchronous display identification code corresponding to the display interface, the following steps are included: sending a connecting request to the control end; receiving a response signal generated by the control end according to the connecting request; and establishing a communication connection with the control end according to the response signal.

In an alternative mode, after establishing a communication connection with the control end according to the response signal, the following steps are included: receiving heartbeat data sent by the control end; and responding to the heartbeat data and sending the response data to the control end so that the control end receives the response heartbeat data.

In an alternative mode, before receiving the vehicle image sent by the camera component, the method further includes: displaying a vehicle measurement interface in synchronization with the control end such that the control end receives an operation instruction from a user for a user interaction interface and sends the operation instruction to the controlled end; and after receiving the operation instruction, controlling the camera component to collect the vehicle image in response to the operation instruction.

In an alternative mode, after receiving the operation instruction, responding to the operation instruction includes: switching and displaying the vehicle measurement interface as an image collection interface, and generating a synchronous display identification code corresponding to the image collection interface; and sending the synchronous display identification code to the control end, so that the control end calls and displays the image collection interface.

According to another aspect of the embodiments of the present invention, there is provided a synchronous screen display method, which is applied to a control end of a vehicle measurement system, the vehicle measurement system comprising a control end, a controlled end, and a vehicle measurement support. The control end is wirelessly connected to the controlled end, the controlled end is mounted to the vehicle measurement support, the vehicle measurement support includes a camera component, the camera component is wired or wirelessly connected to the controlled end, and the camera component is used for collecting a vehicle image and sending the collected vehicle image to the controlled end. The method includes:
receiving the vehicle image sent by the controlled end;
determining a display interface for displaying the vehicle measurement result, and determining a synchronous display identification code corresponding to the display interface;
and sending the vehicle measurement result and the synchronous display identification code to the controlled end, so that the controlled end calls a display interface corresponding to the synchronous display identification code according to the synchronous display identification code, and displays the vehicle measurement result on the display interface.

In an alternative mode, the vehicle measurement result and the synchronous display identification code are character string data; sending the vehicle measurement result and the synchronous display identification code to the controlled end comprises: converting the vehicle measurement result and the synchronous display identification code into binary data; compressing the binary data to obtain compressed data; and sending the compressed data to the controlled end.

In an alternative mode, before receiving the vehicle image sent by the controlled end, the method includes: receiving a connecting request sent by the controlled end; generating a response signal according to the connecting request; and sending the response signal to the controlled end so that the controlled end establishes a communication connection with the control end according to the response signal.

In an alternative mode, after sending the response signal to the controlled end so that the controlled end establishes a communication connection with the control end according to the response signal, the method comprises: sending heartbeat data to the controlled end; and receiving response data of the controlled end to the heartbeat data.

In an alternative mode, before receiving the vehicle image sent by the controlled end, the method includes: displaying a vehicle measurement interface in synchronization with the controlled end; and receiving an operation instruction from a user for a user interaction interface, and sending the operation instruction to the controlled end, so that after receiving the operation instruction, the controlled end controls the camera component to collect a vehicle image in response to the operation instruction.

According to another aspect of the embodiments of the present invention, there is provided a vehicle measurement system comprising a control end, a controlled end, and a vehicle measurement support, the control end and the controlled end being wirelessly connected, the controlled end being mounted to the vehicle measurement support, the vehicle measurement support comprising a camera component, and the camera component being wired or wirelessly connected to the controlled end;
wherein the camera component is used for collecting a vehicle image and sending the collected vehicle image to the controlled end;
the controlled end is used for receiving the vehicle image sent by the camera component;
the controlled end is further used for sending the vehicle image to the control end;
the control end is used for determining a vehicle measurement result according to the vehicle image;
the control end is further used for determining a display interface for displaying the vehicle measurement result, and determining a synchronous display identification code corresponding to the display interface;
the control end is further used for sending the vehicle measurement result and the synchronous display identification code to the controlled end;
the controlled end is further used for calling a display interface corresponding to the synchronous display identification code according to the synchronous display identification code, and displaying the vehicle measurement result on the display interface.

According to another aspect of the embodiments of the present invention, there is provided a synchronous screen display apparatus, which is applied to a controlled end of a vehicle measurement system, the vehicle measurement system comprising a control end, a controlled end, and a vehicle measurement support. The control end is wirelessly connected to the controlled end, the controlled end is mounted to the vehicle measurement support, the vehicle measurement support includes a camera component, the camera component is wired or wirelessly connected to the controlled end, and the camera component is used for collecting a vehicle image and sending the collected vehicle image to the controlled end. The apparatus includes:
a first receiving module for receiving the vehicle image sent by the camera component;
a first sending module for sending the vehicle image to the control end, so that the control end determines a vehicle measurement result according to the vehicle image, determines a display interface for displaying the vehicle measurement result, and determines a synchronous display identification code corresponding to the display interface;
a second receiving module for receiving the vehicle measurement result and the synchronous display identification code sent by the control end; and
a display module for calling a display interface corresponding to the synchronous display identification code according to the synchronous display identification code, and displaying the vehicle measurement result on the display interface.

According to another aspect of the embodiments of the present invention, there is provided a synchronous screen display apparatus, which is applied to a control end of a vehicle measurement system, the vehicle measurement system comprising a control end, a controlled end, and a vehicle measurement support. The control end is wirelessly connected to the controlled end, the controlled end is mounted to the vehicle measurement support, the vehicle measurement support includes a camera component, the camera component is wired or wirelessly connected to the controlled end, and the camera component is used for collecting a vehicle image and sending the collected vehicle image to the controlled end. The apparatus includes:
a third receiving module for receiving the vehicle image sent by the controlled end;
a first determination module for determining a display interface for displaying the vehicle measurement result, and determining a synchronous display identification code corresponding to the display interface; and
a second sending module for sending the vehicle measurement result and the synchronous display identification code to the controlled end, so that the controlled end calls a display interface corresponding to the synchronous display identification code according to the synchronous display identification code, and displays the vehicle measurement result on the display interface.

According to another aspect of the embodiments of the present invention, there is provided a computer-readable storage medium. At least one executable instruction is stored in the storage medium, and when the executable instruction runs on electronic equipment, the electronic equipment executes an operation of the synchronous screen display method mentioned above.

An embodiment of the present invention sets display interface data coinciding with the control end at a controlled end, and sets a synchronous display identification code; the control end sends a lightweight vehicle measurement result and a synchronous display identification code to the controlled end, and the controlled end determines the corresponding display interface according to the synchronous display identification code, thereby enabling the controlled end and the control end to perform synchronous screen display. The response speed is fast and there is no delay, so that the screen between the controlled end and the control end can perform real-time synchronous display.

In addition, secondary data compression is performed on lightweight vehicle measurement result and synchronous display identification code such that data transmission is faster, further improving the display speed of the synchronous screen.

The above description is only an overview of the technical schemes of the embodiments of the invention. In order to understand the technical means of the embodiments of the invention more clearly, it can be implemented according to the contents of the description. In order to make the above and other purposes, features, and advantages of the embodiments of the invention more obvious and understandable, specific implementation modes of the invention are listed below.

### BRIEF DESCRIPTION OF THE DRAWINGS

The drawings are only for the purpose of illustrating the implementation modes and are not to be construed as limiting the present invention. Moreover, like reference numerals denote like components throughout the drawings. In the drawings:
Fig. 1 shows a schematic structural diagram of a vehicle measurement system provided by an embodiment of the invention;
Fig. 2 shows a schematic flow diagram of a synchronous screen display method provided by an embodiment of the present invention;
Fig. 3 shows a schematic flow diagram of a synchronous screen display method provided by another embodiment of the present invention;
Fig. 4 shows a schematic flow diagram of a synchronous screen display method provided by yet another embodiment of the present invention;
Fig. 5 shows a schematic structural diagram of a synchronous screen display apparatus provided by an embodiment of the present invention;
Fig. 6 shows a schematic structural diagram of a synchronous screen display apparatus provided by another embodiment of the present invention.

### DETAILED DESCRIPTION

Hereinafter, exemplary embodiments of the present invention will be described in more detail with reference to the accompanying drawings. While the drawings show exemplary embodiments of the invention, it should be understood that the invention may be implemented in various forms and should not be limited by the embodiments described herein.

Firstly, technical terms appearing in the embodiments of the present invention are explained as follows:
a control end is a general term for the implementation of control and how to specifically operate that end in an automobile inspection process; for example, the scenario that the control end in a four-wheel positioning system of an automobile can be terminal equipment such as a computer, a mobile terminal, or a tablet computer;
a controlled end is a general term for communicating with a control end and the end that is controlled in the automobile inspection process; for example, the controlled end in a four-wheel positioning system;
Json is a data format for Internet transmission;
Portobuf (Protocol Buffers) is a data format developed by Google Inc., similar to XML, which can serialize structured data and can be used for data storage, communication protocol, etc.;
heartbeat is a term indicating that a character is sent to the network at intervals to detect whether it is online.

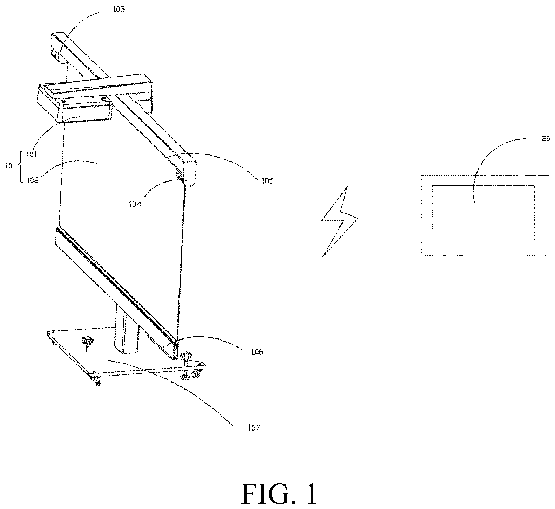

Fig. 1 shows a vehicle measurement system provided by an embodiment of the invention. The vehicle measurement system is used for Advanced Driving Assistant System (ADAS) calibration or four-wheel positioning of an automobile, including a control end 10, a controlled end 20, and a vehicle measurement support (not numbered). The control end 20 is wirelessly connected to the controlled end 10, the controlled end 10 is mounted to a vehicle measurement support, the vehicle measurement support comprises a camera component, the camera component comprises a first camera component 103 and a second camera component 104, and the camera component is wired or wirelessly connected to the controlled end 10. Wherein:
the camera component is used for collecting a vehicle image and sending the collected vehicle image to the controlled end. Specifically, the vehicle image includes a first image and a second image. The first camera component 103 acquires the first image of a tire on the first side face of the vehicle to be inspected and sends the same to the controlled end 10; the second camera component 104 acquires the second image of the tire of the second side face of the vehicle to be inspected and sends the same to the controlled end 10.

The controlled end 10 is used for receiving the vehicle image sent by the camera component. In an embodiment of the present invention, the controlled end 10 includes a processor (not shown) and a display component, which may be an electronic display screen, connected to the processor. In an embodiment of the present invention, the display component may further include a display 102 and a light projecting apparatus 101. The processor receives the first image of the first camera component 103 and the second image of the second camera component 104. The display component is used to display a vehicle inspection result.

The controlled end 10 is also used to send the vehicle image to the control end 20.

The control end 20 is used for determining a vehicle measurement result according to the vehicle image. After receiving the vehicle image, the control end 20 performs data analysis on the vehicle image by using a preset algorithm to obtain a vehicle measurement result. The control end 20 may be a mobile phone, a tablet computer, a computer or like equipment having a control function.

The control end 20 is further used for determining a display interface for displaying the vehicle measurement result, and determining a synchronous display identification code corresponding to the display interface. A display interface corresponding to the vehicle measurement result is pre-stored in the control end 20, and the vehicle measurement result can be displayed on the display interface. Specifically, according to the vehicle measurement result, the display interface, and the corresponding display animation, display interface UI, interface configuration parameter, and other interface display data when the vehicle measurement result is displayed on the display interface are determined, and the vehicle measurement result is displayed and processed according to the interface display data, and the vehicle measurement result is displayed through the display interface.

The control end 20 is further used for sending the vehicle measurement result and the synchronous display identification code to the controlled end 10. In an embodiment of the present invention, the vehicle measurement result and the synchronous display identification code are character string data. Specifically, the control end 20 converts the vehicle measurement result and the synchronous display identification code into binary data; and compresses the binary data to obtain compressed data. After obtaining the compressed data, the compressed data is sent to the controlled end 10. By setting the synchronous display identification code, the control end 20 only needs to send the lightweight data of the vehicle measurement result and the synchronous display identification code, and it is possible to realize a fast synchronous display. At the same time, when the data is sent, by converting and compressing the sent vehicle measurement result and synchronization identification code, the data amount is made smaller, and further, there is no delay on the synchronous display, so as to realize the beneficial effect of the fast synchronous display.

The controlled end 10 is also used for calling a display interface corresponding to the synchronous display identification code according to the synchronous display identification code, and displaying the vehicle measurement result on the display interface. The controlled end 10 decompresses the compressed data to obtain binary data; the binary data is converted into character string data, so as to obtain and receive the vehicle measurement result and the synchronous display identification code sent by the control end 20. A display interface corresponding to the synchronous display identification code is pre-stored in the controlled end 10, the corresponding display interface is called according to the synchronous display identification code, and the vehicle measurement result is displayed on the display interface. The following is specifically included. The controlled end reconstructs the display interface according to the display interface data corresponding to the display interface and the vehicle measurement result to obtain a reconstructed display interface, so as to display the vehicle measurement result on the reconstructed display interface. For example, animation data, interface configuration data, etc. required for the vehicle measurement result are reconstructed together with the display interface data. For example, in one embodiment of the invention, where the vehicle measurement system calibrates a sensor of a vehicle tire, the controlled end 10 displays a calibration pattern on the display interface according to the synchronous display identification code and the vehicle measurement result, the calibration pattern being used to assist in calibrating the sensor in the vehicle to be inspected.

The control end 20 is further configured to adjust the tire of the vehicle according to the calibration pattern.

In an embodiment of the present invention, the controlled end 10 communicates with the control end 20 via a socket, and the controlled end 10 receives the synchronous display identification code sent by the control end 20 via the socket. Before establishing communication, the controlled end 10 sends a connecting request to the control end 20, so that the control 20 end generates a response signal according to the connecting request, and the controlled end 10 establishes a communication connection between the controlled end 10 and the control end 20 according to the response signal.

In an embodiment of the present invention, after the controlled end 10 establishes a communication connection with the control end 20, the communication via a two-way heartbeat mechanism is further performed to determine whether the other end is online in real-time, specifically comprising: after establishing a connection, the control end 20 actively sending heartbeat data to the controlled end 10; and after receiving the heartbeat data, the controlled end 10 sending the response heartbeat data to the control end 20. In an embodiment of the present invention, the control end 20 sends heartbeat 001 data to the controlled end 10, and the controlled end 10 sends response heartbeat data 002 to the control end 20, indicating that this end is online, and the control end 20 sends heartbeat data to the controlled end 10 after receiving the response heartbeat data. This is done back and forth to determine whether both parties are online. If the controlled end 10 or the control end 20 does not receive the heartbeat data or the response heartbeat data of the other party within the preset time, the connection is actively disconnected.

After the disconnection, the data of the controlled end 10 and the control end 20 may be inconsistent, so that the vehicle measurement result needs to be re-determined and re-displayed. Specifically, the corresponding data to be displayed when the control end 20 sends the current heartbeat data is determined. If the current heartbeat data does not receive the response heartbeat data fed back by the control end 10 within a preset time, the current connection is determined to be disconnected. The communication connection between the controlled end 10 and the control end 20 is performed again, and the vehicle measurement result corresponding to the current heartbeat data and the corresponding synchronous display identification code are sent to the controlled end 20 again, so as to synchronize the data of the controlled end 10 and the control end 20.

The vehicle measurement system according to an embodiment of the present invention sets display interface data coinciding with the control end at a controlled end, and sets a synchronous display identification code; the control end sends a lightweight vehicle measurement result and a synchronous display identification code to the controlled end, and the controlled end determines the corresponding display interface according to the synchronous display identification code, thereby enabling the controlled end and the control end to perform real-time line synchronous screen display during vehicle measurement. The response speed is fast and there is no delay, so that the screen between the controlled end and the control end can perform real-time synchronous display. In addition, the response time of the synchronous screen is further shortened by twice compressing the data to make the data more lightweight.

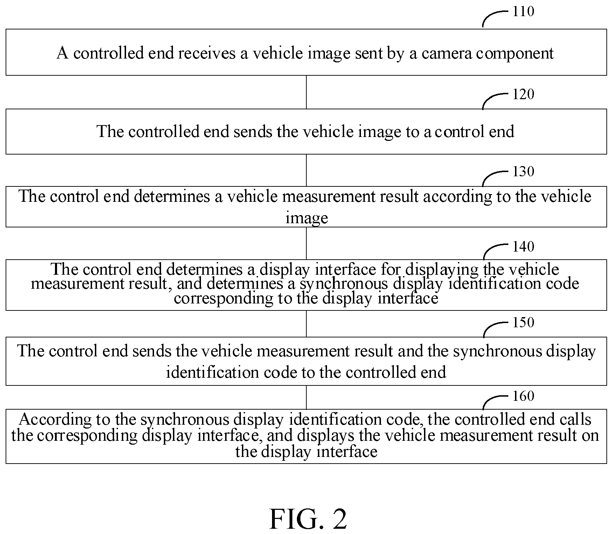

Fig. 2 shows a synchronous screen display method according to an embodiment of the present invention. The method is applied to the vehicle measurement system described above, and the specific structure of the vehicle measurement system is consistent with the embodiment of the vehicle measurement system described above, and will not be described in detail herein. The synchronous screen display method of an embodiment of the present invention comprises the following steps.

Step 110, a controlled end receives a vehicle image sent by a camera component.

Wherein the camera component collects a vehicle image and sends the collected vehicle image to the controlled end; the controlled end includes a processor and a display component connected to the processor; wherein the processor receives the vehicle image sent by the camera component, and wherein the vehicle image includes an image of a wheel, an image of a target attached to the wheel, an image of the vehicle contour, an image of a sensor included in vehicle ADAS, or an image of a specific part of a vehicle;

Step 120, the controlled end sends the vehicle image to a control end.

In an embodiment of the present invention, after receiving the vehicle image, the controlled end may directly send the same to the control end, or may send the same to the control end after performing certain processing. The controlled end sends data to the control end via a socket.

Before the controlled end sends the vehicle image to the control end, it further includes establishing a communication connection between the controlled end and the control end, including:
the controlled end sending a connecting request to the control end;
the control end generating a response signal according to the connecting request;
and the controlled end establishing a communication connection with the control end according to the response signal.

Step 130, the control end determines a vehicle measurement result according to the vehicle image.

After receiving the vehicle image, the control end performs data analysis on the vehicle image by using a preset algorithm to obtain a vehicle measurement result. The vehicle measurement result comprises a wheel positioning parameter, or a positioning parameter of the vehicle measurement support relative to the vehicle, and also comprises a test reference parameter at the time of measurement corresponding to the vehicle measurement result, such as a collection range.

Step 140, the control end determines a display interface for displaying the vehicle measurement result, and determines a synchronous display identification code corresponding to the display interface. In an embodiment of the present invention, the synchronous display identification code is an identification code uniquely corresponding to the display interface pre-agreed by the controlled end and the control end, which may be a JSON character string or a number, etc. For example, 0000 is used to represent the vehicle measurement interface, 0001 is used to represent the image collection interface, and 0010 is used to represent the vehicle measurement result display interface, etc.

A display interface corresponding to the vehicle measurement result is pre-stored in the control end, and the vehicle measurement result can be displayed on the display interface. Specifically, according to the vehicle measurement result, the display interface, and the corresponding display type, display animation, display interface UI, interface configuration parameter, and other interface display data when the vehicle measurement result is displayed on the display interface are determined, and the vehicle measurement result is displayed and processed according to the interface display data, and the vehicle measurement result is displayed through the display interface.

In an embodiment of the present invention, a synchronous display identification code corresponding to the vehicle measurement result and the display interface is provided at the control end, so that the corresponding display interface and the synchronous display identification code can be determined after the vehicle measurement result is determined. Different display interfaces correspond to different synchronous display identification codes. The control end parses the vehicle measurement result and displays the same on a display interface of the control end, and the display interface may be determined according to a user operation. At the same time, whether synchronization is required is determined according to the parsing result or user operation information. When synchronization is required, a synchronization command is generated, and the control end assembles the vehicle measurement results into JSON data according to the synchronization command, determines its corresponding unique synchronous display identification code according to the display interface of the vehicle measurement results, and combines the assembled JSON data with the synchronous display identification code, thereby sending the combined data to the controlled end. The process of generating a synchronization command comprises: determining whether it is a first-time measurement result according to the analysis result, and if it is the first-time measurement result, automatically determining that synchronization is required, and then generating a synchronization command. If it is not the first-time measurement result, it is determined whether user operation information is received, and it is determined whether synchronization is required according to the user operation information, and a synchronization command is generated when synchronization is required.

Step 150, the control end sends the vehicle measurement result and the synchronous display identification code to the controlled end.

The embodiment of the present invention correspondingly provides a display interface and display interface data corresponding to the synchronous display identification code at the controlled end, so that the control end only needs to send the vehicle measurement result and the synchronous display identification code to determine the corresponding display interface. Therefore, the amount of data transmission during synchronous screen display is greatly reduced, improving the efficiency of the synchronous screen display.

In an embodiment of the present invention, the vehicle measurement result and the synchronous display identification code are character string data. For example, they may be JSON data. Specifically, the control end converts the vehicle measurement result and the synchronous display identification code into binary data; and compresses the binary data to obtain compressed data. After obtaining the compressed data, the compressed data is sent to the controlled end. By setting the synchronous display identification code, the control end only needs to send the lightweight data of the vehicle measurement result and the synchronous display identification code, and it is possible to realize a fast synchronous display. At the same time, when the data is sent, by converting and compressing the sent vehicle measurement result and synchronization identification code, the data amount is made smaller, and further, there is no delay on the synchronous display, so as to realize the beneficial effect of the fast synchronous display.

Step 160, the controlled end calls a display interface corresponding to the synchronous display identification code according to the synchronous display identification code, and displays the vehicle measurement result on the display interface.

The processor of the controlled end receives the synchronous display identification code and the vehicle measurement result, and decompresses the same. The decompression process includes the following steps. The controlled end decompresses the compressed data to obtain binary data; the binary data is converted into character string data, so as to obtain and receive the vehicle measurement result and the synchronous display identification code sent by the control end. A display interface corresponding to the synchronous display identification code is pre-stored in the controlled end, and the corresponding display interface is called according to the synchronous display identification code such that the vehicle measurement result is displayed on the display interface.

In an embodiment of the present invention, a processor determines a display interface and interface display data corresponding to a vehicle measurement result according to a synchronous display identification code, processes the display interface according to the vehicle measurement result, and sends the same to a display component for display. The controlled end stores display interface data of a display interface consistent with the control end, and the display interface data corresponds to the synchronous display identification code. After receiving the synchronous display identification code, the controlled end determines a display interface name according to the synchronous display identification code, and queries a storage path of the display interface data in a corresponding relationship table of the display interface name and the display interface data according to the display interface name so as to determine the display interface data corresponding to the synchronous display identification code at the controlled end. The interface display data comprises interface display data such as a display type, a display animation, a display interface UI and interface configuration parameters of the display interface. The UI management program of the controlled end calls the corresponding display interface data in the storage path, reconstructs the display interface according to the vehicle measurement result and the interface display data, and fills a parameter in the vehicle measurement result to a corresponding position of the display interface according to field information of the vehicle measurement result, thereby displaying the vehicle measurement result on the display interface of the controlled end.

In an embodiment of the present invention, before the controlled end receives the vehicle image sent by the camera component, it further includes the steps:
a controlled end and a control end synchronously displaying a vehicle measurement interface;
wherein the control end receives an operation instruction from a user on a user interaction interface, and sends the operation instruction to the controlled end;
after receiving the operation instruction, the controlled end controls the camera component to collect a vehicle image in response to the operation instruction. After the controlled end receives the operation instruction, a specific process of responding to the operation instruction comprises steps as follows: the controlled end switches and displays the vehicle measurement interface as an image collection interface, and generates a synchronous display identification code corresponding to the image collection interface; the controlled end sends the synchronous display identification code to the control end, so that the control end calls and displays the image collection interface.

The synchronous screen display method of an embodiment of the present invention, after establishing a communication connection between the controlled end and the control end, further performs communication via a two-way heartbeat mechanism to determine whether the other end is online in real-time, specifically comprising: after establishing the connection, the control end actively sending heartbeat data to the controlled end; and after receiving the heartbeat data, the controlled end sending response heartbeat data to the control end. In an embodiment of the present invention, the control end sends heartbeat data to the controlled end, and the controlled end sends response heartbeat data to the control end, indicating that this end is online, and the control end sends heartbeat data to the controlled end after receiving the response heartbeat data. This is done back and forth to determine whether both parties are online. If the controlled end or the control end does not receive the heartbeat data or the response heartbeat data of the other party within the preset time, the connection is actively disconnected.

A synchronous screen display method according to an embodiment of the present invention sets display interface data coinciding with the control end at a controlled end, and sets a synchronous display identification code; the control end sends a lightweight vehicle measurement result and a synchronous display identification code to the controlled end, and the controlled end determines the corresponding display interface according to the synchronous display identification code, thereby enabling the controlled end and the control end to perform real-time synchronous screen display during vehicle measurement. The response speed is fast and there is no delay, so that the screen between the controlled end and the control end can perform real-time synchronous display. In addition, the response time of the synchronous screen is further shortened by twice compressing the data to make the data more lightweight.

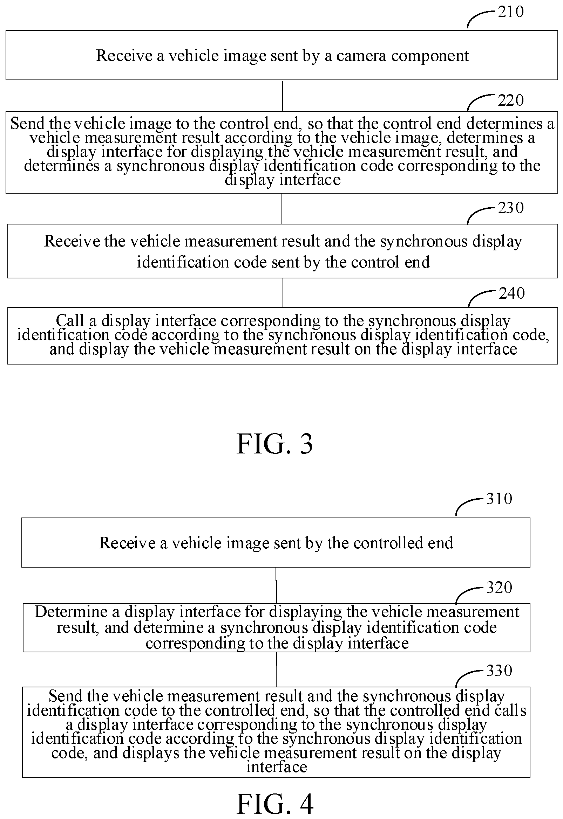

Fig. 3 shows a schematic flow diagram of a synchronous screen display method provided by another embodiment of the present invention. The synchronous screen display method of an embodiment of the present invention is applied to a controlled end of a vehicle measurement system, the vehicle measurement system comprising a control end, a controlled end, and a vehicle measurement support. The control end is wirelessly connected to the controlled end, the controlled end is mounted to the vehicle measurement support, the vehicle measurement support includes a camera component, the camera component is wired or wirelessly connected to the controlled end, and the camera component is used for collecting a vehicle image and sending the collected vehicle image to the controlled end. This vehicle measurement system has a structure consistent with the embodiment of the vehicle measurement system described above, and will not be described in detail here. The synchronous screen display method according to an embodiment of the present invention comprises the following steps:
step 210, receiving a vehicle image sent by a camera component;
wherein the camera component collects a vehicle image and sends the collected vehicle image to the controlled end; the controlled end includes a processor and a display component connected to the processor; and wherein the processor receives the vehicle image sent by the camera component;
and step 220: sending the vehicle image to the control end, so that the control end determines a vehicle measurement result according to the vehicle image, determines a display interface for displaying the vehicle measurement result, and determines a synchronous display identification code corresponding to the display interface.

In an embodiment of the present invention, after the vehicle image is received, it can be directly sent to the control end, or sent to the control end after being subjected to certain processing. The data is sent to the control end via a socket.

After receiving the vehicle image, the control end performs data analysis on the vehicle image by using a preset algorithm to obtain a vehicle measurement result. A display interface corresponding to the vehicle measurement result is pre-stored in the control end, and the vehicle measurement result can be displayed on the display interface. Specifically, according to the vehicle measurement result, the display interface, and the corresponding display animation, display interface UI, interface configuration parameter, and other interface display data when the vehicle measurement result is displayed on the display interface are determined, and the vehicle measurement result is displayed and processed according to the interface display data, and the vehicle measurement result is displayed through the display interface. A synchronous display identification code corresponding to the vehicle measurement result and the display interface is provided at the control end, so that the corresponding display interface and the synchronous display identification code can be determined after the vehicle measurement result is determined.

Prior to sending the vehicle image to the control end, the following is further included: establishing a communication connection between the controlled end and the control end, including: sending a connecting request to the control end; receiving a response signal generated by the control end according to the connecting request; and establishing a communication connection with the control end according to the response signal.

Step 230: receive the vehicle measurement result and the synchronous display identification code sent by the control end.

The controlled end of the embodiment of the present invention is correspondingly provided with a display interface and display interface data corresponding to the synchronous display identification code, so that the control end only needs to send the vehicle measurement result and the synchronous display identification code to determine the corresponding display interface. Therefore, the amount of data transmission during synchronous screen display is greatly reduced, improving the efficiency of the synchronous screen display.

The vehicle measurement result and the synchronous display identification code are character string data, such as JSON data. The control end also compresses the vehicle measurement result and the synchronous display identification code before sending the vehicle measurement result and the synchronous display identification code. The control end converts the vehicle measurement result and the synchronous display identification code into binary data; and compresses the binary data to obtain compressed data. After obtaining the compressed data, the compressed data is sent to the controlled end. By setting the synchronous display identification code, the control end only needs to send the lightweight data of the vehicle measurement result and the synchronous display identification code, and it is possible to realize a fast synchronous display. At the same time, when the data is sent, by converting and compressing the sent vehicle measurement result and synchronization identification code, the data amount is made smaller, and further, there is no delay on the synchronous display, so as to realize the beneficial effect of the fast synchronous display.

Therefore, after the vehicle measurement result and the synchronous display identification code sent by the control end are received, the compressed data is decompressed to obtain binary data; the binary data is converted into character string data, so as to obtain and receive the vehicle measurement result and the synchronous display identification code sent by the control end.

In an embodiment of the present invention, different display interfaces correspond to different synchronous display identification codes. The control end parses the vehicle measurement result and displays the same on a display interface of the control end, and the display interface may be determined according to a user operation. At the same time, whether synchronization is required is determined according to the parsing result or user operation information. When synchronization is required, a synchronization command is generated, and the control end assembles the vehicle measurement results into JSON data according to the synchronization command, determines its corresponding unique synchronous display identification code according to the display interface of the vehicle measurement results, and combines the assembled JSON data with the synchronous display identification code, thereby sending the combined data to the controlled end. The process of generating a synchronization command comprises: determining whether it is a first-time measurement result according to the analysis result, and if it is the first-time measurement result, automatically determining that synchronization is required, and then generating a synchronization command. If it is not the first-time measurement result, it is determined whether user operation information is received, and it is determined whether synchronization is required according to the user operation information, and a synchronization command is generated when synchronization is required.

Step 240, call a display interface corresponding to the synchronous display identification code according to the synchronous display identification code, and display the vehicle measurement result on the display interface.

The processor of the controlled end receives the synchronous display identification code and the vehicle measurement result, and decompresses the same. The decompression process includes the following steps. The controlled end decompresses the compressed data to obtain binary data; the binary data is converted into character string data, so as to obtain and receive the vehicle measurement result and the synchronous display identification code sent by the control end. A display interface corresponding to the synchronous display identification code is pre-stored in the controlled end, and the corresponding display interface is called according to the synchronous display identification code such that the vehicle measurement result is displayed on the display interface. Specifically, the controlled end stores display interface data of a display interface consistent with the control end, and the display interface data corresponds to the synchronous display identification code. After receiving the synchronous display identification code, the controlled end determines a display interface name according to the synchronous display identification code, and queries a storage path of the display interface data in a corresponding relationship table of the display interface name and the display interface data according to the display interface name so as to determine the display interface data corresponding to the synchronous display identification code at the controlled end. The interface display data comprises interface display data such as a display type, a display animation, a display interface UI and interface configuration parameters of the display interface. The UI management program of the controlled end calls the corresponding display interface data in the storage path, reconstructs the display interface according to the vehicle measurement result and the interface display data, and fills a parameter in the vehicle measurement result to a corresponding position of the display interface according to field information of the vehicle measurement result, thereby displaying the vehicle measurement result on the display interface of the controlled end.

In an embodiment of the invention, prior to receiving the vehicle image sent by the camera component, the method further comprises:
displaying a vehicle measurement interface in synchronization with the control end such that the control end receives an operation instruction from a user for a user interaction interface and sends the operation instruction to the controlled end;
and after receiving the operation instruction, controlling the camera component to collect a vehicle image in response to the operation instruction. After receiving the operation instruction, a specific process of responding to the operation instruction comprises steps as follows: the controlled end switches and displays the vehicle measurement interface as an image collection interface, and generates a synchronous display identification code corresponding to the image collection interface; the synchronous display identification code is sent to the control end, so that the control end calls and displays the image collection interface.

The synchronous screen display method of an embodiment of the present invention, after establishing a communication connection between the controlled end and the control end, further performs communication via a two-way heartbeat mechanism to determine whether the other end is online in real-time, specifically comprising: after establishing the connection, the control end actively sending heartbeat data to the controlled end; and after receiving the heartbeat data, the controlled end sending response heartbeat data to the control end. In an embodiment of the present invention, the control end sends heartbeat data to the controlled end, and the controlled end sends response heartbeat data to the control end, indicating that this end is online, and the control end sends heartbeat data to the controlled end after receiving the response heartbeat data. This is done back and forth to determine whether both parties are online. If the controlled end or the control end does not receive the heartbeat data or the response heartbeat data of the other party within the preset time, the connection is actively disconnected.

A synchronous screen display method according to an embodiment of the present invention sets display interface data coinciding with the control end at a controlled end, and sets a synchronous display identification code; the control end sends a lightweight vehicle measurement result and a synchronous display identification code to the controlled end, and the controlled end determines the corresponding display interface according to the synchronous display identification code, thereby enabling the controlled end and the control end to perform real-time synchronous screen display during vehicle measurement. The response speed is fast and there is no delay, so that the screen between the controlled end and the control end can perform real-time synchronous display. In addition, the response time of the synchronous screen is further shortened by twice compressing the data to make the data more lightweight.

Fig. 4 shows a schematic flow diagram of a synchronous screen display method provided by yet another embodiment of the present invention. The synchronous screen display method of an embodiment of the present invention is applied to a control end of a vehicle measurement system, the vehicle measurement system comprising a control end, a controlled end, and a vehicle measurement support. The control end is wirelessly connected to the controlled end, the controlled end is mounted to the vehicle measurement support, the vehicle measurement support includes a camera component, the camera component is wired or wirelessly connected to the controlled end, and the camera component is used for collecting a vehicle image and sending the collected vehicle image to the controlled end. This vehicle measurement system has a structure consistent with the embodiment of the vehicle measurement system described above, and will not be described in detail here. The synchronous screen display method according to an embodiment of the present invention comprises the following steps:
step 310: receiving a vehicle image sent by the controlled end;
wherein the camera component collects a vehicle image and sends the collected vehicle image to the controlled end; the controlled end sends the vehicle image to the control end; the controlled end includes a processor and a display component connected to the processor; and wherein the processor receives the vehicle image sent by the camera component. In the embodiment of the present invention, the controlled end may directly send the vehicle data to the control end or may send the same to the control end after performing certain processing. The controlled end communicates with the control end via a socket.

In an embodiment of the invention, prior to sending the vehicle image to the control end, the following is further included: establishing a communication connection between the controlled end and the control end, including: sending a connecting request to the control end; receiving a response signal generated by the control end according to the connecting request; and establishing a communication connection with the control end according to the response signal.

Step 320, determine a display interface for displaying the vehicle measurement result, and determine a synchronous display identification code corresponding to the display interface.

After receiving the vehicle image, the control end performs data analysis on the vehicle image by using a preset algorithm to obtain a vehicle measurement result. A display interface corresponding to the vehicle measurement result is pre-stored in the control end, and the vehicle measurement result can be displayed on the display interface. Specifically, according to the vehicle measurement result, the display interface, and the corresponding display animation, display interface UI, interface configuration parameter, and other interface display data when the vehicle measurement result is displayed on the display interface are determined, and the vehicle measurement result is displayed and processed according to the interface display data, and the vehicle measurement result is displayed through the display interface. A synchronous display identification code corresponding to the vehicle measurement result and the display interface is provided at the control end, so that the corresponding display interface and the synchronous display identification code can be determined after the vehicle measurement result is determined.

In an embodiment of the present invention, different display interfaces correspond to different synchronous display identification codes. The control end parses the vehicle measurement result and displays the same on a display interface of the control end, and the display interface may be determined according to a user operation. At the same time, whether synchronization is required is determined according to the parsing result or user operation information. When synchronization is required, a synchronization command is generated, and the control end assembles the vehicle measurement results into JSON data according to the synchronization command, determines its corresponding unique synchronous display identification code according to the display interface of the vehicle measurement results, and combines the assembled JSON data with the synchronous display identification code, thereby sending the combined data to the controlled end. The process of generating a synchronization command comprises: determining whether it is a first-time measurement result according to the analysis result, and if it is the first-time measurement result, automatically determining that synchronization is required, and then generating a synchronization command. If it is not the first-time measurement result, it is determined whether user operation information is received, and it is determined whether synchronization is required according to the user operation information, and a synchronization command is generated when synchronization is required.

Step 330: send the vehicle measurement result and the synchronous display identification code to the controlled end, so that the controlled end calls a display interface corresponding to the synchronous display identification code according to the synchronous display identification code, and displays the vehicle measurement result on the display interface.

The controlled end of the embodiment of the present invention is correspondingly provided with a display interface and display interface data corresponding to the synchronous display identification code, so that the control end only needs to send the vehicle measurement result and the synchronous display identification code to determine the corresponding display interface. Therefore, the amount of data transmission during synchronous screen display is greatly reduced, improving the efficiency of the synchronous screen display.

In an embodiment of the present invention, the vehicle measurement result and the synchronous display identification code are character string data, such as JSON data. The vehicle measurement result and the synchronous display identification code are also compressed before the vehicle measurement result and the synchronous display identification code are sent to the controlled end. The control end converts the vehicle measurement result and the synchronous display identification code into binary data; and compresses the binary data to obtain compressed data. After obtaining the compressed data, the compressed data is sent to the controlled end. By setting the synchronous display identification code, the control end only needs to send the lightweight data of the vehicle measurement result and the synchronous display identification code, and it is possible to realize a fast synchronous display. At the same time, when the data is sent, by converting and compressing the sent vehicle measurement result and synchronization identification code, the data amount is made smaller, and further, there is no delay on the synchronous display, so as to realize the beneficial effect of the fast synchronous display.

Specifically, the controlled end stores display interface data of a display interface consistent with the control end, and the display interface data corresponds to the synchronous display identification code. After receiving the synchronous display identification code, the controlled end determines a display interface name according to the synchronous display identification code, and queries a storage path of the display interface data in a corresponding relationship table of the display interface name and the display interface data according to the display interface name so as to determine the display interface data corresponding to the synchronous display identification code at the controlled end. The interface display data comprises interface display data such as a display type, a display animation, a display interface UI and interface configuration parameters of the display interface. The UI management program of the controlled end calls the corresponding display interface data in the storage path, reconstructs the display interface according to the vehicle measurement result and the interface display data, and fills a parameter in the vehicle measurement result to a corresponding position of the display interface according to field information of the vehicle measurement result, thereby displaying the vehicle measurement result on the display interface of the controlled end.

In an embodiment of the present invention, before the control end receives the vehicle image sent by the controlled end, the method comprises:
displaying a vehicle measurement interface in synchronization with the controlled end;
and receiving an operation instruction from a user for a user interaction interface, and sending the operation instruction to the controlled end, so that after receiving the operation instruction, the controlled end controls the camera component to collect a vehicle image in response to the operation instruction. After the controlled end receives the operation instruction, a specific process of responding to the operation instruction comprises: the control end receiving a synchronous display identification code corresponding to an image collection interface, and calling and displaying the image collection interface corresponding to the synchronous display identification code. The synchronous screen display method of an embodiment of the present invention, after establishing a communication connection between the controlled end and the control end, further performs communication via a two-way heartbeat mechanism to determine whether the other end is online in real-time, specifically comprising: after establishing the connection, the control end actively sending heartbeat data to the controlled end; and after receiving the heartbeat data, the controlled end sending response heartbeat data to the control end. In an embodiment of the present invention, the control end sends heartbeat data to the controlled end, and the controlled end sends response heartbeat data to the control end, indicating that this end is online, and the control end sends heartbeat data to the controlled end after receiving the response heartbeat data. This is done back and forth to determine whether both parties are online. If the controlled end or the control end does not receive the heartbeat data or the response heartbeat data of the other party within the preset time, the connection is actively disconnected.

A synchronous screen display method according to an embodiment of the present invention sets display interface data coinciding with the control end at a controlled end, and sets a synchronous display identification code; the control end sends a lightweight vehicle measurement result and a synchronous display identification code to the controlled end, and the controlled end determines the corresponding display interface according to the synchronous display identification code, thereby enabling the controlled end and the control end to perform real-time synchronous screen display during vehicle measurement. The response speed is fast and there is no delay, so that the screen between the controlled end and the control end can perform real-time synchronous display. In addition, the response time of the synchronous screen is further shortened by twice compressing the data to make the data more lightweight.

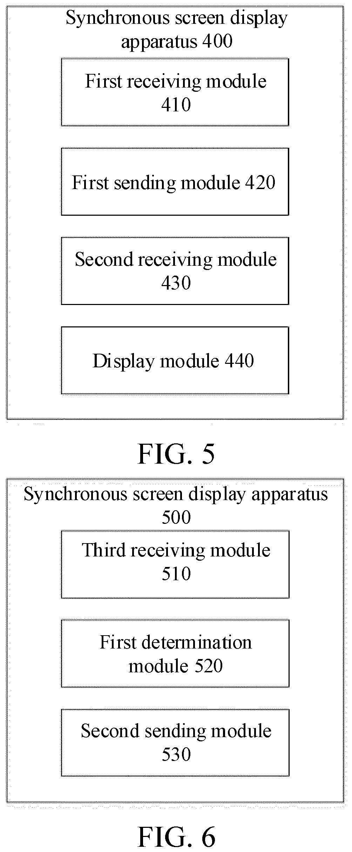

Fig. 5 shows a schematic structural diagram of a synchronous screen display apparatus provided by an embodiment of the present invention. As shown in Fig. 5, the apparatus 400 is applied to a controlled end of a vehicle measurement system, the vehicle measurement system comprising a control end, a controlled end, and a vehicle measurement support. The control end is wirelessly connected to the controlled end, the controlled end is mounted to the vehicle measurement support, the vehicle measurement support includes a camera component, the camera component is wired or wirelessly connected to the controlled end, and the camera component is used for collecting a vehicle image and sending the collected vehicle image to the controlled end. The vehicle measurement system includes a structure consistent with the vehicle measurement system in the above-described embodiment, and will not be described in detail herein. The apparatus includes a first receiving module 410, a first sending module 420, a second receiving module 430, and a display module 440.

The first receiving module 410 is used for receiving a vehicle image sent by the camera component;
the first sending module 420 is used for sending the vehicle image to the control end, so that the control end determines a vehicle measurement result according to the vehicle image, determines a display interface for displaying the vehicle measurement result, and determines a synchronous display identification code corresponding to the display interface;
the second receiving module 430 is used for receiving the vehicle measurement result and the synchronous display identification code sent by the control end;
the display module 440 is used for calling a display interface corresponding to the synchronous display identification code according to the synchronous display identification code, and displaying the vehicle measurement result on the display interface.

The specific working process of the synchronous screen display apparatus 400 in the embodiment of the present invention is consistent with the specific implementation steps of the synchronous screen display method applied to the control end described above, and will not be described herein.

Fig. 6 shows a schematic structural diagram of a synchronous screen display apparatus provided by an embodiment of the present invention. As shown in Fig. 6, the apparatus 500 is applied to a control end of a vehicle measurement system, the vehicle measurement system comprising a control end, a controlled end, and a vehicle measurement support. The control end is wirelessly connected to the controlled end, the controlled end is mounted to the vehicle measurement support, the vehicle measurement support includes a camera component, the camera component is wired or wirelessly connected to the controlled end, and the camera component is used for collecting a vehicle image and sending the collected vehicle image to the controlled end. This vehicle measurement system has a structure consistent with the embodiment of the vehicle measurement system described above, and will not be described in detail here. The apparatus includes a third receiving module 510, a first determination module 520, and a second sending module 530.

The third receiving module 510 is used for receiving the vehicle image sent by the controlled end;
the first determination module 520 is used for determining a display interface for displaying the vehicle measurement result, and determining a synchronous display identification code corresponding to the display interface;
the second sending module 530 is used for sending the vehicle measurement result and the synchronous display identification code to the controlled end, so that the controlled end calls a display interface corresponding to the synchronous display identification code according to the synchronous display identification code, and displays the vehicle measurement result on the display interface.

The specific working process of the synchronous screen display apparatus 500 in the embodiment of the present invention is consistent with the specific implementation steps of the synchronous screen display method applied to the controlled end described above, and will not be described herein.

An embodiment of the present invention provides a computer-readable storage medium storing thereon at least one executable instruction. The executable instruction, when running on electronic equipment, causes the electronic equipment to execute the following steps:
receiving a vehicle image sent by a camera component;
sending the vehicle image to the control end, so that the control end determines a vehicle measurement result according to the vehicle image, determines a display interface for displaying the vehicle measurement result, and determines a synchronous display identification code corresponding to the display interface;
receiving the vehicle measurement result and the synchronous display identification code sent by the control end;
and calling a display interface corresponding to the synchronous display identification code according to the synchronous display identification code, and displaying the vehicle measurement result on the display interface;
   or,
receiving a vehicle image sent by the controlled end;
determining a display interface for displaying the vehicle measurement result, and determining a synchronous display identification code corresponding to the display interface;
and sending the vehicle measurement result and the synchronous display identification code to the controlled end, so that the controlled end calls a display interface corresponding to the synchronous display identification code according to the synchronous display identification code, and displays the vehicle measurement result on the display interface.

The specific working process of the computer-readable storage medium in the embodiment of the present invention when running on electronic equipment is the same as the specific steps in the above method embodiment, and thus will not be repeated herein.

The embodiment of the present invention sets display interface data coinciding with the control end at a controlled end, and sets a synchronous display identification code; the control end sends a lightweight vehicle measurement result and a synchronous display identification code to the controlled end, and the controlled end determines the corresponding display interface according to the synchronous display identification code, thereby enabling the controlled end and the control end to perform real-time synchronous screen display during vehicle measurement. The response speed is fast and there is no delay, so that the screen between the controlled end and the control end can perform real-time synchronous display. In addition, the response time of the synchronous screen is further shortened by twice compressing the data to make the data more lightweight.

An embodiment of the present invention provides a synchronous screen display apparatus for executing the above synchronous screen display method.

An embodiment of the present invention provides a computer program that can be called by a processor to cause electronic equipment to execute the synchronous screen display method in any of the above method embodiments.

An embodiment of the disclosure provides a computer program product including a computer program stored on a computer-readable storage medium. The computer program includes program instructions which, when running on a computer, cause the computer to execute the synchronous screen display method of any of the method embodiments described above.

The algorithm or display provided herein is not inherently related to any particular computer, virtual system, or other devices. Various general-purpose systems may also be used with the teachings based on what is disclosed herein. According to the above description, the structure required to construct such a system is obvious. Furthermore, embodiments of the present invention are not directed to any particular programming language. It should be understood that the contents of the invention described herein can be realized by using various programming languages, and the description of the specific language is to disclose the best implementation mode of the invention.

In the description provided herein, numerous specific details are set forth. However, it could be understood that embodiments of the invention may be practiced without these specific details. In some instances, well-known methods, structures, and techniques have not been shown in detail in order not to obscure the understanding of this description.

Similarly, it should be understood that in the above description of example embodiments of the invention, various features of the embodiments of the invention are sometimes grouped together in a single embodiment, figure, or the description thereof for the purpose of streamlining the invention and aiding in the understanding of one or more of the various inventive aspects. However, the disclosed method should not be interpreted as reflecting the intention that the claimed invention requires more features than those clearly recorded in each claim.

It could be understood by those skilled in the art that the modules in the devices in the embodiments may be changed adaptively and arranged in one or more devices different from the embodiment. Modules or units or assemblies in an embodiment may be combined into one module or unit or assembly and may be divided into a plurality of sub-modules or sub-units or sub-assemblies. Except that at least some of such features and/or processes or units are mutually exclusive, all features disclosed in the description (including accompanying claims, abstract, and drawings) and all processes or units of any method or device so disclosed can be combined in any combination. Each feature disclosed in the description (including any accompanying claims, abstract, and drawings) may be replaced by alternative features serving the same, equivalent, or similar purpose, unless expressly stated otherwise.

It should be noted that the above-mentioned embodiments illustrate rather than limit the invention, and that those skilled in the art can design alternative embodiments without departing from the scope of the appended claims. In the claims, any reference sign placed in a bracket shall not be construed as limiting the claims. The word "comprising" does not exclude the presence of an element or a step other than those listed in a claim. The word "a" or "one" preceding an element does not exclude the presence of a plurality of such elements. The present invention can be implemented by means of hardware comprising several distinct elements, and by means of a suitably programmed computer. In a unit claim enumerating several devices, several devices of these devices can be specifically embodied by one and the same item of hardware. The use of the words first, second, third, etc. does not denote any order. These words may be interpreted as names. The steps in the above embodiments are not to be construed as limiting the order of execution unless otherwise specified.

## Claims

1. A synchronous screen display method, being applied to a vehicle measurement system, the vehicle measurement system comprising a control end, a controlled end, and a vehicle measurement support, wherein the control end is wirelessly connected to the controlled end, the controlled end is mounted to the vehicle measurement support, the vehicle measurement support comprises a camera component, the camera component is wired or wirelessly connected to the controlled end, and the camera component is used for collecting a vehicle image and sending collected vehicle image to the controlled end, the method comprising:
the controlled end receiving the vehicle image sent by the camera component;
the controlled end sending the vehicle image to the control end;
the control end determining a vehicle measurement result according to the vehicle image;
the control end determining a display interface for displaying the vehicle measurement result, and determining a synchronous display identification code corresponding to the display interface;
the control end sending the vehicle measurement result and the synchronous display identification code to the controlled end; and
the controlled end calling a display interface corresponding to the synchronous display identification code according to the synchronous display identification code, and displaying the vehicle measurement result on the display interface.

2. The method according to claim 1, wherein the vehicle measurement result and the synchronous display identification code are character string data; the control end sending the vehicle measurement result and the synchronous display identification code to the controlled end comprises:
the control end converting the vehicle measurement result and the synchronous display identification code into binary data;
the control end compressing the binary data to obtain compressed data; and
the control end sending the compressed data to the controlled end.

3. The method according to claim 1, before the controlled end sending the vehicle image to the control end, further comprising:
the controlled end sending a connecting request to the control end;
the control end generating a response signal according to the connecting request;
and the controlled end establishing a communication connection with the control end according to the response signal.

4. The method according to claim 3, after the controlled end establishing a communication connection with the control end according to the response signal, further comprising:
the control end sending heartbeat data to the controlled end;
the controlled end responding to the heartbeat data and sending response data to the control end; and
the control end receiving the response heartbeat data.

5. The method according to claim 1, before the controlled end receiving the vehicle image sent by the camera component, further comprising:
the controlled end and the control end synchronously displaying a vehicle measurement interface;
the control end receiving an operation instruction of a user for a user interaction interface, and sending the operation instruction to the controlled end; and
after receiving the operation instruction, the controlled end controlling the camera component to collect vehicle image in response to the operation instruction.

6. The method according to claim 5, wherein after receiving the operation instruction, the controlled end responding to the operation instruction comprises:
the controlled end switching and displaying the vehicle measurement interface as an image collection interface, and generating a synchronous display identification code corresponding to the image collection interface; and
the controlled end sending the synchronous display identification code to the control end, so that the control end calls and displays the image collection interface.

7. A synchronous screen display method, being applied to a controlled end of a vehicle measurement system, the vehicle measurement system comprising a control end, a controlled end, and a vehicle measurement support, wherein the control end is wirelessly connected to the controlled end, the controlled end is mounted to the vehicle measurement support, the vehicle measurement support comprises a camera component, the camera component is wired or wirelessly connected to the controlled end, and the camera component is used for collecting a vehicle image and sending collected vehicle image to the controlled end, the method comprising:
receiving the vehicle image sent by the camera component;
sending the vehicle image to the control end, so that the control end determines a vehicle measurement result according to the vehicle image, determines a display interface for displaying the vehicle measurement result, and determines a synchronous display identification code corresponding to the display interface;
receiving the vehicle measurement result and the synchronous display identification code sent by the control end;
and calling a display interface corresponding to the synchronous display identification code according to the synchronous display identification code, and displaying the vehicle measurement result on the display interface.

8. The method according to claim 7, after receiving the vehicle measurement result and the synchronous display identification code sent by the control end, comprising:
decompressing the compressed data to obtain binary data; and
converting the binary data into character string data, so as to obtain and receive the vehicle measurement result and the synchronous display identification code sent by the control end.

9. The method according to claim 7, before sending the vehicle image to the control end so that the control end determines a vehicle measurement result according to the vehicle image, determines a display interface for displaying the vehicle measurement result, and determines a synchronous display identification code corresponding to the display interface, comprising:
sending a connecting request to the control end;
receiving a response signal generated by the control end according to the connecting request; and
establishing a communication connection with the control end according to the response signal.

10. The method according to claim 7, after establishing a communication connection with the control end according to the response signal, comprising:
receiving heartbeat data sent by the control end; and
responding to the heartbeat data and sending the response data to the control end so that the control end receives the response heartbeat data.

11. The method according to claim 7, before receiving the vehicle image sent by the camera component, further comprising:
displaying a vehicle measurement interface in synchronization with the control end such that the control end receives an operation instruction from a user for a user interaction interface and sends the operation instruction to the controlled end;
and after receiving the operation instruction, controlling the camera component to collect the vehicle image in response to the operation instruction.

12. The method according to claim 11, wherein after receiving the operation instruction, responding to the operation instruction comprises:
switching and displaying the vehicle measurement interface as an image collection interface, and generating a synchronous display identification code corresponding to the image collection interface; and
sending the synchronous display identification code to the control end, so that the control end calls and displays the image collection interface.

13. A synchronous screen display method, being applied to a control end of a vehicle measurement system, the vehicle measurement system comprising a control end, a controlled end, and a vehicle measurement support, wherein the control end is wirelessly connected to the controlled end, the controlled end is mounted to the vehicle measurement support, the vehicle measurement support comprises a camera component, the camera component is wired or wirelessly connected to the controlled end, and the camera component is used for collecting a vehicle image and sending collected vehicle image to the controlled end, the method comprising:
receiving the vehicle image sent by the controlled end;
determining a display interface for displaying the vehicle measurement result, and determining a synchronous display identification code corresponding to the display interface;
and sending the vehicle measurement result and the synchronous display identification code to the controlled end, so that the controlled end calls a display interface corresponding to the synchronous display identification code according to the synchronous display identification code, and displays the vehicle measurement result on the display interface.

14. The method according to claim 13, wherein the vehicle measurement result and the synchronous display identification code are character string data; sending the vehicle measurement result and the synchronous display identification code to the controlled end comprises:
converting the vehicle measurement result and the synchronous display identification code into binary data;
compressing the binary data to obtain compressed data; and
sending the compressed data to the controlled end.

15. The method according to claim 14, before receiving the vehicle image sent by the controlled end, comprising:
receiving a connecting request sent by the controlled end;
generating a response signal according to the connecting request; and
sending the response signal to the controlled end so that the controlled end establishes a communication connection with the control end according to the response signal.

16. The method according to claim 14, wherein after sending the response signal to the controlled end so that the controlled end establishes a communication connection with the control end according to the response signal, the method comprises:
sending heartbeat data to the controlled end; and
receiving response data of the controlled end to the heartbeat data.

17. The method according to claim 14, before receiving the vehicle image sent by the controlled end, comprising:
displaying a vehicle measurement interface in synchronization with the controlled end;
and receiving an operation instruction from a user for a user interaction interface, and sending the operation instruction to the controlled end, so that after receiving the operation instruction, the controlled end controls the camera component to collect a vehicle image in response to the operation instruction.

18. A vehicle measurement system, wherein the vehicle measurement system comprises a control end, a controlled end, and a vehicle measurement support, the control end and the controlled end being wirelessly connected, the controlled end being mounted to the vehicle measurement support, the vehicle measurement support comprising a camera component, and the camera component being wired or wirelessly connected to the controlled end;
wherein the camera component is used for collecting a vehicle image and sending collected vehicle image to the controlled end;
the controlled end is used for receiving the vehicle image sent by the camera component;
the controlled end is further used for sending the vehicle image to the control end;
the control end is used for determining a vehicle measurement result according to the vehicle image;
the control end is further used for determining a display interface for displaying the vehicle measurement result, and determining a synchronous display identification code corresponding to the display interface;
the control end is further used for sending the vehicle measurement result and the synchronous display identification code to the controlled end;
the controlled end is further used for calling a display interface corresponding to the synchronous display identification code according to the synchronous display identification code, and displaying the vehicle measurement result on the display interface.

19. A synchronous screen display apparatus, being applied to a controlled end of a vehicle measurement system, the vehicle measurement system comprising a control end, a controlled end, and a vehicle measurement support, wherein the control end is wirelessly connected to the controlled end, the controlled end is mounted to the vehicle measurement support, the vehicle measurement support comprises a camera component, the camera component is wired or wirelessly connected to the controlled end, and the camera component is used for collecting a vehicle image and sending collected vehicle image to the controlled end, the apparatus comprising:
a first receiving module for receiving the vehicle image sent by the camera component;
a first sending module for sending the vehicle image to the control end, so that the control end determines a vehicle measurement result according to the vehicle image, determines a display interface for displaying the vehicle measurement result, and determines a synchronous display identification code corresponding to the display interface;
a second receiving module for receiving the vehicle measurement result and the synchronous display identification code sent by the control end; and
a display module for calling a display interface corresponding to the synchronous display identification code according to the synchronous display identification code, and displaying the vehicle measurement result on the display interface.

20. A synchronous screen display apparatus, being applied to a control end of a vehicle measurement system, the vehicle measurement system comprising a control end, a controlled end, and a vehicle measurement support, wherein the control end is wirelessly connected to the controlled end, the controlled end is mounted to the vehicle measurement support, the vehicle measurement support comprises a camera component, the camera component is wired or wirelessly connected to the controlled end, and the camera component is used for collecting a vehicle image and sending collected vehicle image to the controlled end, the apparatus comprising:
a third receiving module for receiving the vehicle image sent by the controlled end;
a first determination module for determining a display interface for displaying the vehicle measurement result, and determining a synchronous display identification code corresponding to the display interface; and
a second sending module for sending the vehicle measurement result and the synchronous display identification code to the controlled end, so that the controlled end calls a display interface corresponding to the synchronous display identification code according to the synchronous display identification code, and displays the vehicle measurement result on the display interface.

21. A computer-readable storage medium, wherein at least one executable instruction is stored in the storage medium, and when the executable instruction runs on electronic equipment, the electronic equipment executes an operation of the synchronous screen display method according to any one of claims 7-17.
